# EUROPEAN PATENT APPLICATION

(11) **EP 1 437 660 A2**
(43) Date of publication of application: **14.07.2004**
(21) Application number: 03029229.6
(22) Date of filing: 18.12.2003
(51) Int. Cl.: G06F 13/16

(54) **Semiconductor memory device and mount-type semiconductor device**

(30) Priority: 27.12.2002 JP 2002382326
(71) Applicant: NEC CORPORATION, Tokyo (JP)
(72) Inventor: Ishikawa, Hisashi, Kofu-shi Yamanashi (JP)
(74) Representative: VOSSIUS & PARTNER

(57) **Abstract**

A semiconductor memory device can provide a memory device (2) different in the cost and the performance using the same hardware by simply replacing a memory different in the type. This semiconductor memory device includes a bank busy circuit (11) for variably setting a bank busy time that controls different bank cycle times, thereby controlling a memory different in the bank cycle time, a read data input circuit (14) for inputting read data output from the memory in variable input timing, a write data output circuit (13) for outputting write data to the memory in variable output timing, a command control circuit for controlling different command interfaces, a write mask circuit (15) for controlling different write masks, an initial sequence control circuit for controlling a memories different in the initial sequence, and an address generation circuit (16) for controlling different address interfaces.

## Description

The present invention relates to a semiconductor memory device which controls different types of memory devices using the same hardware, and specifically relates to a semiconductor memory device and a mount-type semiconductor device which control different types of memories such as an FCRAM (Fast cycle Random Access Memory), an NWRAM (NetWork RAM) or a DDR (Double Data Rate)-DRAM (Dynamic Random Access Memory) which are different in the AC specifications, the initial sequence, the capacity, the case size, the pin assignment, the power supply, the interface, and the like.

There has been a semiconductor memory device which can variably changes the effective capacity as one chip without reducing the repair efficiency as a semiconductor memory device which controls different types of memories (JP-A- 2000-132994 . FIGS. 1A and 1B are drawings (FIG. 6 of said JP-A) showing this semiconductor memory device. This semiconductor memory is a four-bank 256M bytes/128M bytes compatible SDRAM, and includes a fuse circuit of a 128M byte-adapted version 132, a selector 133 for selecting either an output signal R12T output from the fuse set circuit 132 or a row address signal RADT<12>, and a row address latch circuit 134 which is connected to the selector 133, and a latch circuit 135, all of which are serving as an address switch circuit 131 connected between a row address buffer 105 and a repair circuit 122. The 128M byte-adapted version fuse set circuit 132 includes fuse set circuits 121a and 121b. Then, a normally operable memory mat is arbitrarily fixed by dividing the bit line direction into 1/2, 1/4, or the like in the respective memory array banks Bank 0 to Bank 3 based on outputs of row address signals RABT<12> and RATT<12> of the address switch circuit 131, there by converting the 256M byte capacity into the 128M byte capacity.

However, the semiconductor memory device described in this publication has the following problems. First, though it is possible to switch the capacity for the same type of memories, it is not possible to switch the capacity for different types of memories such as an FCRAM and a DDR. This is because this conventional semiconductor memory device cannot carry out the control unless the memories have the same specifications except for the memory capacity.

Thus, there is a need for development of a memory control circuit of a memory device including a memory device which uses the same hardware, and controls different types of memory devices such as an FCRAM or an NWRAM, and a DDR-DRAM, which are different in the AC specifications, the initial sequence, the capacity, the case size, the pin assignment, the power supply, and the interface.

A purpose of the present invention is to provide a semiconductor memory device and a mount-type semiconductor device which can provide memory devices different in the cost and the performance simply by switching among memories different in the type using the same hardware, can thus increase the variation and property of products, and can reduce the development cost and the number of types of component parts to be used by eliminating the necessity of the development of memory devices for respective different memories, thereby reducing the cost of the component parts.

A semiconductor memory device according to the present invention includes a memory; and a memory control circuit for controlling the memory. The memory control circuit includes a bank busy circuit for variably setting a bank busy time that controls different bank cycle times, a read data input circuit for inputting read data output from the memory in variable input timing, a write data output circuit for outputting write data to the memory in variable output timing, a command control circuit for issuing a command to the memory based on a memory command output from the bank busy circuit, thereby controlling different command interfaces, a write mask circuit for controlling different write masks, an initial sequence control circuit for controlling memories different in the initial sequence, and an address generation circuit for controlling different address interfaces. The memory control circuit controls different memories using the same hardware.

In this semiconductor memory device, for example, the bank busy circuit includes a program register for variably setting the bank busy time, and a bank busy counter for setting a value set on the program register when a bank n is accessed for turning on, and then counting down the set value for each clock cycle. The bank busy counter provides the command control circuit with a memory command indicating cleared bank busy when the logic value of the bank busy counter becomes zero, thereby controlling memories different in the bank cycle time.

For example, the read data input circuit includes a first program register for variably setting the input timing of the read data output from the memory for controlling memories different in the access time, and inputs the read data output from the memory based on a set value on the first program register in variable input timing. The write data output circuit includes a second program register for variably setting the output timing of the write data output to the memory, and can adjust write data output timing based on a set value on the second program register.

The bank busy circuit may switch the bank busy time using a switch.

For example, the write mask circuit relates to mask control for the write data output to the memory, and has a program register for switching between masking write operation using a variable write function when an FCRAM or an NWRAM is used, and masking the write operation using a Data Mask function when a DDR-SDRAM is used.

Alternatively, the write mask circuit relates to the mask control for the write data output to the memory, and may have a switch for switching between masking of write operation using a variable Write function when an FCRAM or an NWRAM is used, and masking of the write operation using a Data Mask function when a DDR-SDRAM is used.

For example, the address generation circuit relates to address generation of memories different in address assignment, and includes a program register for switching address generation logic.

Alternatively, the address generation circuit relates to the address generation of memories different in address assignment, and has a switch for switching the address generation logic.

In addition, the initial sequence control circuit relates to control of memories different in the initial sequence, for example, includes a program register for variably changing the issue sequence of commands including mode register set, extension mode register set, auto refresh, and all bank pre-charge, and for variably changing set values on a mode register and an extension mode register, controls the memories different in the initial sequence using the same circuit, and issues an initial sequence command including the mode register set, the extension mode register set, the auto refresh, and the all bank pre-charge to the command control circuit.

Alternatively, the initial sequence control circuit relates to the control of the memories different in the initial sequence, may include a switch for variably changing the issue sequence of commands including the mode register set, the extension mode register set, the auto refresh, and the all bank pre-charge, and for variably changing the set values on the mode register and the extension mode register, controls the memories different in the initial sequence using the same circuit, and issues an initial sequence command including the mode register set, the extension mode register set, the auto refresh, and the all bank pre-charge to the command control circuit.

For example, the semiconductor memory device comprises a power supply capable of adjusting a power supply output level supplied for the memory. In this way, it is not necessary to change the power supply even when a different memory is mounted in terms of the power supply for a memory having different power supply voltage. Alternately, the mount of a different memory can be handled only by changing a memory power supply of a power supply unit without changing a board for mounting the memory.

A mount-type semiconductor device according to the present invention is a mount-type semiconductor device for mounting the above-described semiconductor memory device on a board. The memory is different in the package size or the pin assignment, and only a board for mounting the memory is changed, and one type of mother board is used for connecting the board for mounting the memory thereon when the memory different in the package size or the pin assignment is mounted.

The board for mounting the memory thereon is a DIMM (Dual Inline Memory Module), for example.

A mount-type semiconductor device according to the present invention is a mount-type semiconductor device for mounting the above-described semiconductor memory device on a board. The memory is different in whether a terminating resistor is incorporated or not, and when the memory which is different in whether a terminating resistor is incorporated or not is mounted, a terminating resistor is not mounted on a DIMM (Dual Inline Memory Module) for the memory incorporating a terminating resistor, a terminating resistor is attached to a DIMM for the memory not incorporating a terminating resistor, and one type of mother board is provided for connecting to the board for mounting the memory thereon.

According to the present invention, since it is possible to construct memories different in the performance and the price using the same hardware, the variation of products can increase. In addition, though it has been necessary to develop dedicated memory devices to include different types of memories into a product group, since it is possible to use different types of memories in the same hardware according to the present invention, there is provided such an effect as reduction of the cost of the component parts by reduction of the development cost and reduction of the types of the component parts.
The invention will be further described with reference to the drawings.

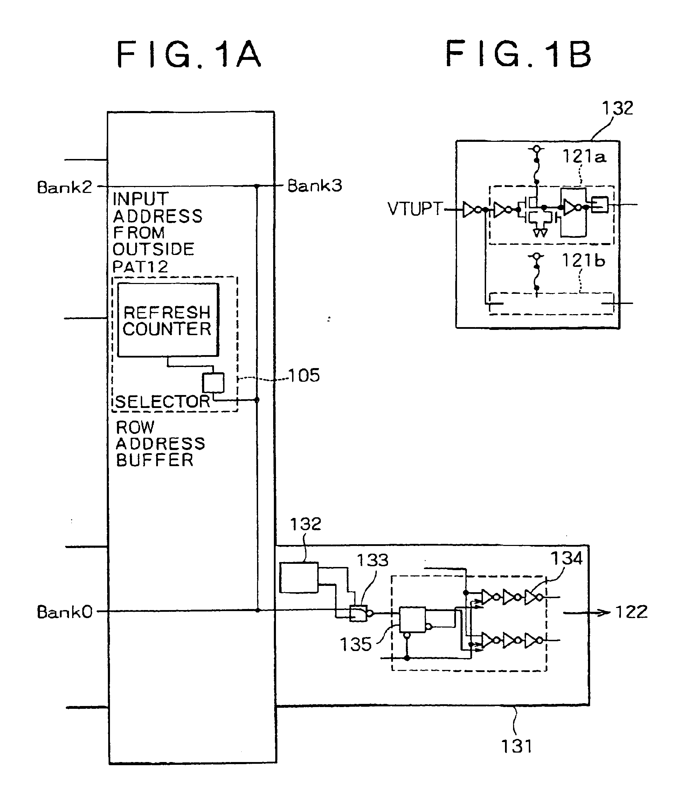

FIGS. 1A and 1B show conventional semiconductor memory device;
FIG. 2 is a block diagram showing an embodiment of the present invention;
FIG. 3 shows a bank busy circuit;
FIG. 4 is a write time chart of a DDR2;
FIG. 5 is a write time chart of an FCRAM or an NWRAM;
FIG. 6 shows how to realize compatible memory pin assignments;
FIG. 7 shows how to supply a memory different in the power supply voltage with power;
FIG. 8 details a pin assignment; and
FIG. 9 details a pin assignment.

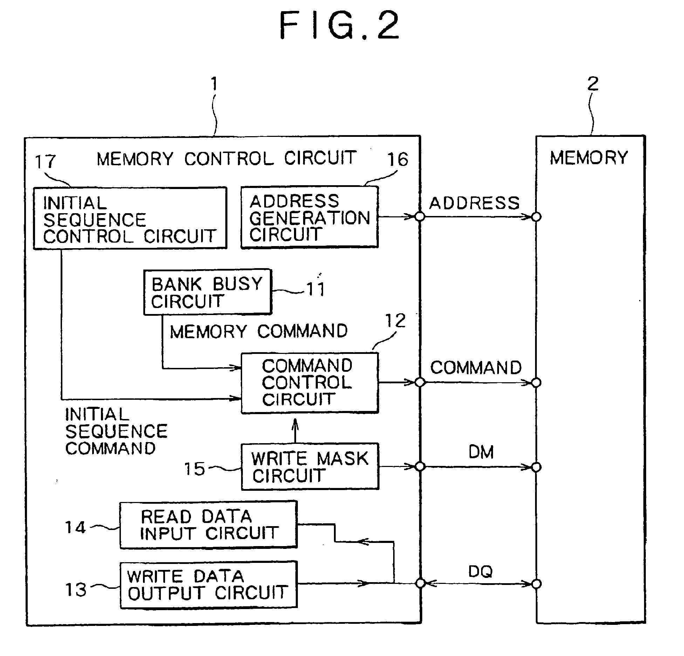

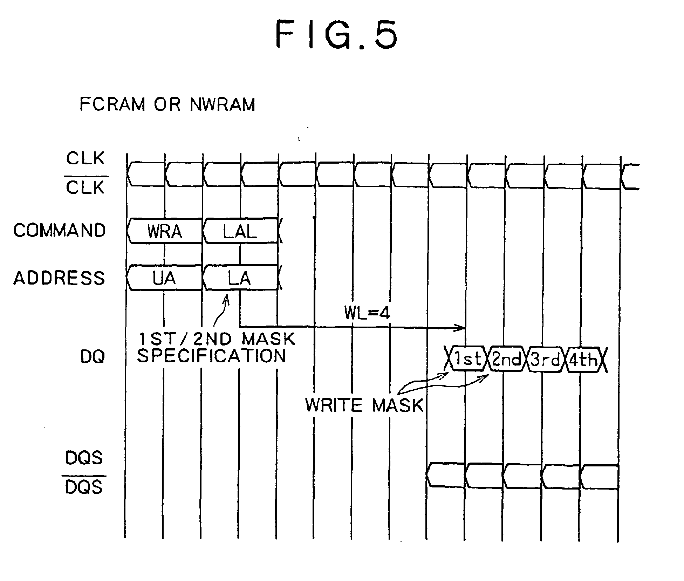

A specific description will now be given of embodiments of the present invention with reference to accompanying drawings. FIG. 2 is a block diagram showing a semiconductor memory device according to an embodiment of the present invention. A memory control circuit 1 controls a memory 2 of this semiconductor memory device. A bank busy circuit 11 of this memory control circuit 1 can variably set a bank busy time for controlling different bank cycle times, thereby controlling memories having different bank cycle times. A read data input circuit 14 variably changes input timing of read data output from the memory 2. A write data output circuit 13 variably changes output timing of write data output to the memory. A command control circuit 12 can control different command interfaces. A write mask circuit 15 can control different write masks. An initial sequence circuit 17 can control memories having different initial sequences. An address generation circuit 16 can control different address interfaces. When signals shown in FIG. 5 are connected to this memory control circuit 1, the memory control circuit 1 can control different memories 2 using the same hardware.

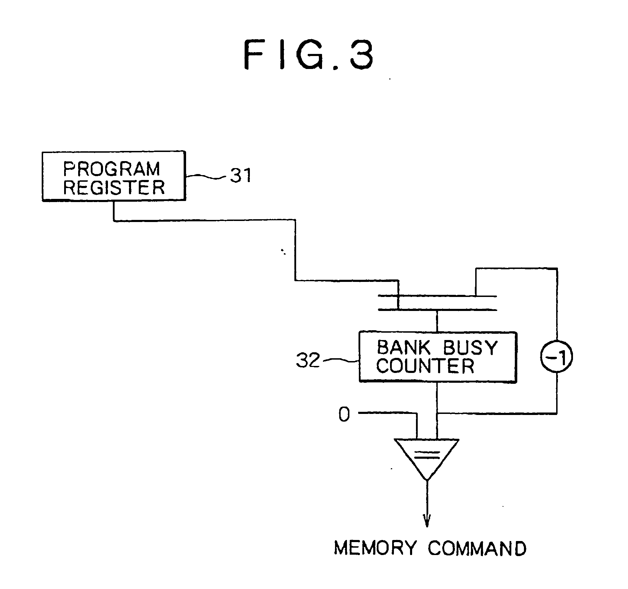

FIG. 3 shows a block diagram showing the specific construction of the bank busy circuit 11. The bank busy circuit 11 which controls memories different in the bank cycle time includes a program register 31 which can variably set the bank busy time, and a bank busy counter 32 which sets a value set on the program register and counts down the set value every clock cycle when a bank n (n≧1) is accessed for turning on. In this way, when the count of the bank busy counter 32 becomes logical zero, bank busy is cleared, and thus the bank busy circuit 11 issues a memory command to the command circuit 12. The value of the bank busy counter 32 is not logical zero, since the status is bank busy, and the bank busy circuit 11 controls the bank cycle by not issuing the memory command.

The read data input circuit 14 includes a first program register (not shown) for variably setting input timing of read data output from the memory 2 for controlling memories different in the access time, and inputs the read data output from the memory based on a set value of the first program register. The write data output circuit 13 includes a second program register (not shown) for variably setting the output timing of the write data output to the memory, and adjusts write data output timing based on a set value on the second program register. As a result, memory control different in the latency is enabled.

The write mask circuit 15 relates to mask control of the write data to the memory, outputs a Variable Write signal to the command circuit 12 for masking write operation when an FCRAM or an NWRAM is used, and outputs a Data Mask signal for masking the write operation when a DDR-SDRAM is used. In this way, the memory is controlled during the write mask operation.

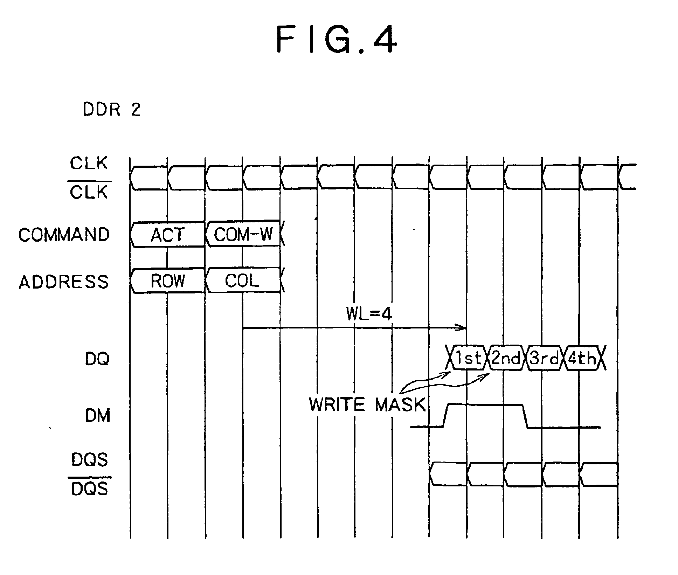

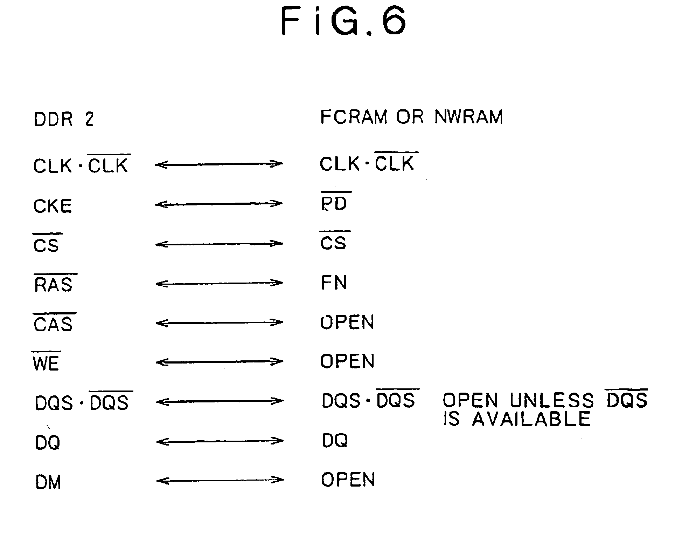

The command control circuit 12 inputs the variable write signal from the write mask circuit 15, outputs a signal shown in a time chart of FIG. 4 when a DDR-SDRAM is used, and outputs a signal shown in a time chart of FIG. 5 when an FCRAM or an NWRAM is used. In this way, the write mask circuit 15 masks the write operation using the Data Mask function when a DDR-SDRAM is used, and masks the write operation using the variable Write function when an FCRAM or an NWRAM is used. In this case, the correspondence of the pin assignments is controlled by switching as shown in FIG. 6.

The address generation circuit 16 relates to address generation for memory devices different in address assignment, and switches address generation logic using a program register (not shown).

The initial sequence control circuit 17 relates to control of memory devices different in the initial sequence, includes a program register (not shown) for variably controlling the issue sequence of commands including mode register set, extension mode register set, auto refresh, all bank pre-charge, and for variably changing set values on a mode register and an extension mode register, controls the memories different in the initial sequence using the same circuit, and issues an initial sequence command including the mode register set, the extension mode register set, the auto refresh, and the all bank pre-charge to the command control circuit 12.

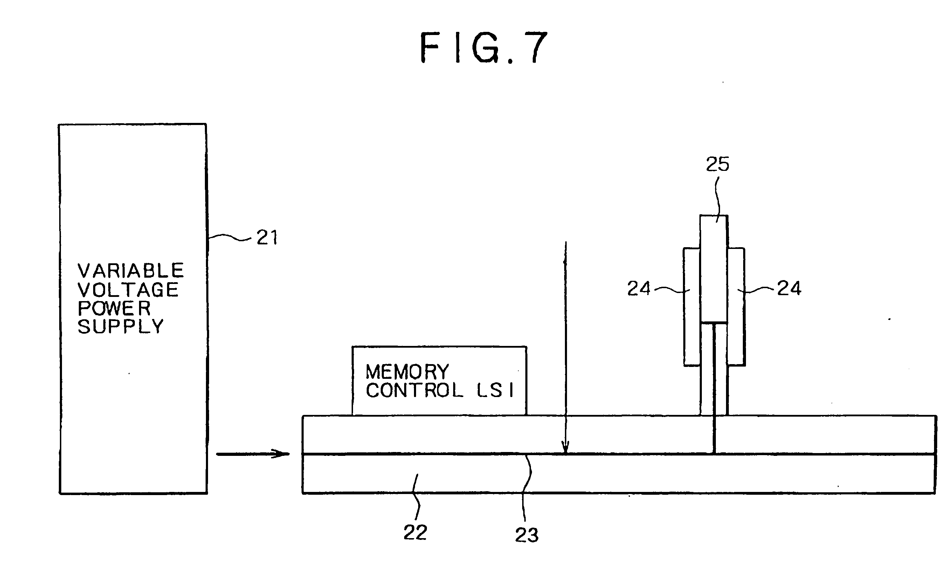

When the power is supplied for a memory device requiring a different power supply voltage, if there is disposed a power supply 21 which can adjust the power supply output level supplied for the memory as shown in FIG. 7, it is not necessary to change the power supply even if a different memory device 24 is mounted. Note that reference numeral 22 denotes a board; 23, a power supply layer for a memory device inside the board; 25, a DIMM (Dual Inline Memory Module); and 26, a memory control LSI.

In this way, it is possible to mount memories different in the power supply voltage such as a DDR2 requiring 1.8V, and an FCRAM or an NWRAM requiring 2.5V while using the same hardware.

Alternatively, if only a memory power supply is changed in a power supply unit, it is possible to supply the memory device different in the power supply voltage with the power without changing the board for mounting the memory.

When a memory device different in the package size or the pin assignment (arrangement) is mounted, only the board such as a DIMM (Dual Inline.Memory Module) is changed for mounting the memory, and the same type of mother board is used for connecting the board for the memory mount.

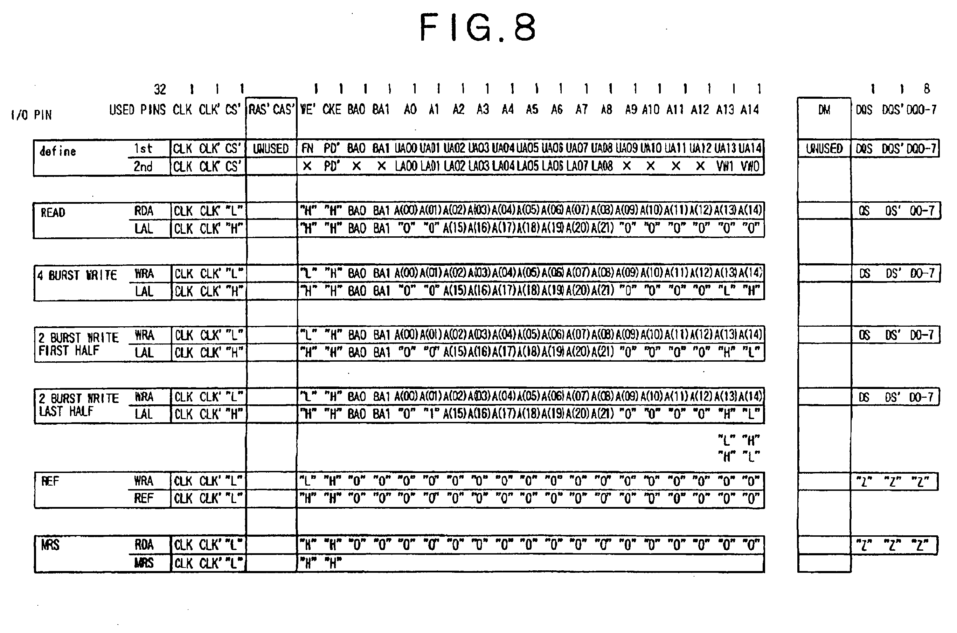

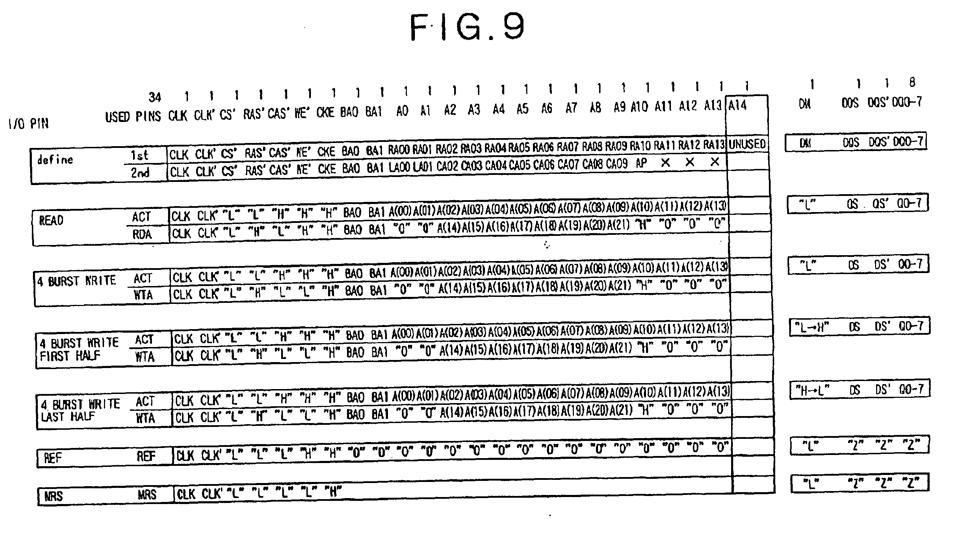

FIG. 8 and FIG. 9 show the pin assignments (I/O pin definition). FIG. 8 shows a 512Mb×8, 4-BANK, BL4 FCRAM, and FIG. 9 shows a 512Mb×8, 4-BANK, BL4 DDR2.

In the pin combinations of the FCRAM (NWRAM) and the DDR2, row address inputs are referred to as RDA and WRA for the FCRAM, and ACT, MRS, and REF for the DDR2. Column address inputs are referred to as LAL, REF, and MRS for the FCRAM, and RDA and WTA for the DDR2.

As shown in FIG. 8 and FIG. 9, CLK and CLK' can be realized using the same hardware both for the FCRAM and the DDR2, and a DQ pin can also be realized using the same hardware both for the FCRAM and the DDR2. Since a CS pin requires a "L" output both for the FCRAM and the DDR2 during the row address input, and requires the "L" output only for the DDR2 during the column address input, the CS pin can be controlled easily in terms of the hardware quantity and the delay.

Since control simply inverting the polarity of WE and FN pins for the read/write can be used for the row address input and the column address input respectively in the FCRAM and the DDR2, the WE and FN pins can be controlled easily in terms of the hardware quantity and the delay. It is necessary to guarantee "L" on POW-ON, and then "H" after an elapse of a certain period for CKE and PD pins, the same hardware can realizes this control both for the FCRAM and the DDR2. The same hardware can realize control for BA pins both for the FCRAM and the DDR2. Since the FCRAM and the DDR2 require different numbers of pins as AD pins, the pin assignments shown in FIG. 8 and FIG. 9 can reduce the number of pins. In terms of the presence/absence of a DM pin, while the DM pin is used for the write mask function for the DDR2, the DM pin is not used for the FCRAM. When the FCRAM is used, an A0-1 field and A13-A14 are used to specify respective write masks for a fast half and a last half. According to the above described control, the two types of memory devices can be easily controlled in terms of the delay using the small amount of hardware.

In terms of the mount of a memory incorporating a terminating resistor and a memory not incorporating a terminating resistor, a terminating resistor is not mounted on the DIMM for the memory incorporating a terminating resistor, and a terminating resistor is mounted on the DIMM for the memory not incorporating a terminating resistor, thereby using only one type of mother board connected to the board for the memory mount.

In the semiconductor device constructed in this way, the same hardware can control various types of memories such as the FCRAM or the NWRAM and the DDR-DRAM different in the AC specifications, the initial sequence, the capacity, the case size, the pin assignment, the power supply, the interface, and the like.

Note that in place of the program registers according to the above described embodiment, switches may be used as hardware to switch the bank busy time, the mask function applied to the write operation, the address generation logic, and the like.

Also, note that the pin assignment for memories different in the pin interface is not always fixed.

## Claims

1. A semiconductor memory device comprising:
a memory (2); and
a memory control circuit (1) for controlling said memory,
**characterized in that**:
said memory control circuit (1) includes:
a bank busy circuit (11) for variably setting a bank busy time that controls different bank cycle times;
a read data input circuit (14) for inputting read data output from said memory in variable input timing;
a write data output circuit (13) for outputting write data to said memory in variable output timing;
a command control circuit (12) for issuing a command to said memory based on a memory command output from said bank busy circuit, thereby controlling different command interfaces;
a write mask circuit (15) for controlling different write masks;
an initial sequence control circuit (17) for controlling memories different in the initial sequence; and
an address generation circuit (16) for controlling different address interfaces, and
said memory control circuit (1) controls different memories using the same hardware.

2. The semiconductor memory device according to claim 1, **characterized in that**:
said bank busy circuit (11) includes:
a program register (31) for variably setting the bank busy time; and
a bank busy counter (32) for setting a value set on said program register, and then counting down the set value for each clock cycle when a bank n is accessed for turning on, and
said bank busy circuit (11) provides said command control circuit with a memory command indicating cleared bank busy when the logic value of said bank busy counter becomes zero, thereby controlling memories different in the bank cycle time.

3. The memory device according to claim 1 or 2, wherein
said read data input circuit (14) includes a first program register for variably setting the input timing of the read data output from said memory for controlling memories different in the access time, and inputs the read data output from said memory based on a set value on the first program register in variable input timing, and
said write data output circuit (13) comprises a second program register for variably setting the output timing of the write data output to said memory, and adjusts the write data output timing based on a set vale on the second program register.

4. The memory device according to claim 1, 2 or 3, wherein said bank busy circuit (32) switches the bank busy time using a switch.

5. The memory device according to claim 1, 2, 3 or 4, wherein
said write mask circuit (15) relates to mask control for the write data output to said memory, and has a program register for switching between masking write operation using a Variable Write function when an FCRAM or an NWRAM is used, and masking the write operation using a Data Mask function when a DDR-SDRAM is used.

6. The memory device according to any one of claims 1 to 5, wherein
said write mask circuit (15) relates to mask control for the write data output to said memory, and has a switch for switching between masking of write operation using a Variable write function when an FCRAM or an NWRAM is used, and masking of the write operation using a Data Mask function when a DDR-SDRAM is used.

7. The memory device according to any one of claims 1 to 6, wherein
said address generation circuit (16) relates to address generation of memories different in address assignment, and includes a program register for switching address generation logic.

8. The memory device according to any one of claims 1 to 7, wherein
said address generation circuit (16) relates to address generation of memories different in address assignment, and includes a switch for switching address generation logic.

9. The memory device according to any one of claims 1 to 8, wherein
said initial sequence control circuit (17) relates to control of memories different in the initial sequence, includes a program register for variably changing the issue sequence of commands including mode register set, extension mode register set, auto refresh, and all bank pre-charge, and for variably changing set values on a mode register and an extension mode register, controls said memories different in the initial sequence using the same circuit, and issues an initial sequence command including the mode register set, the extension mode register set, the auto refresh, and the all banK pre-charge to said command control circuit.

10. The memory device according to any one of claims 1 to 9, wherein
said initial sequence control circuit (17) relates to control of memories having different initial sequences, includes a switch for variably changing the issue sequence of commands including mode register set, extension mode register set, auto refresh, and all bank pre-charge, and for variably changing set values on a mode register and an extension mode register, controls said memories different in the initial sequence using the same circuit, and issues an initial sequence command including the mode register set, the extension mode register set, the auto refresh, and the all bank pre-charge to said command control circuit.

11. The memory device according to any one claims 1 to 10, further comprising a power supply (21) capable of adjusting a power supply output level supplied for said memory.

12. A mount-type semiconductor device for mounting said semiconductor memory device according to any one of claims 1 to 11 on a board, **characterized in that**:
said memory is different in the package size or the pin assignment, only the board for mounting the memory is changed, and one type of mother board is used for connecting the board for mounting the memory thereon when the memory different in the package size or the pin assignment is mounted.

13. The mount-type semiconductor device according to claim 12, **characterized in that** the board for mounting the memory thereon is a DIMM (Dual Inline Memory Module).

14. A mount-type semiconductor device for mounting said semiconductor memory device according to any one of claims 1 to 11 on a board, **characterized in that**:
said memory is different in whether a terminating resistor is incorporated or not, and when the memory which is different in whether a terminating resistor is incorporated or not is mounted, a terminating resistor is not mounted on a DIMM (Dual Inline Memory Module) for the memory incorporating a terminating resistor, and a terminating resistor is attached to a DIMM for the memory not incorporating a terminating resistor, and one type of mother board is provided for connecting to the board for mounting the memory thereon.
